# FASCICULE DE BREVET EUROPEEN

(11) **EP 1 844 340 B1**
(45) Date de publication et mention de la délivrance du brevet: **27.07.2011**
(21) Numéro de dépôt: 05825167.9
(22) Date de dépôt: 14.12.2005
(51) Int. Cl.: G01R 19/155

(54) **PROCEDE ET DISPOSITIF POUR DETERMINER LES CARACTERISTIQUES DE LA TENSION ELECTRIQUE D'UNE INSTALLATION ELECTRIQUE.**
VERFAHREN UND EINRICHTUNG ZUR BESTIMMUNG DER KENNGRÖSSEN DER SPANNUNG EINER ELEKTRISCHEN INSTALLATION
METHOD AND DEVICE FOR DETERMINING THE CHARACTERISTICS OF THE VOLTAGE OF AN ELECTRICAL INSTALLATION

(30) Priorité: 31.01.2005 FR 0550274
(43) Date de publication de la demande: 17.10.2007
(73) Titulaire: Fameca, Société par actions simpliflée, 68170 Rixheim (FR)
(72) Inventeur: ROSS, Guy, Beloeil (quebec), J3G 3L7 (CA); MIHAILOVIC, Marc, F-90110 Rougemont-le-chateau (FR)
(74) Mandataire: Rhein, Alain
(86) Numéro de dépôt international: PCT/FR2005/051085
(87) Numéro de publication internationale: WO 2006/082289

(56) Documents cités:
- US-A- 4 316 254

## Description

La présente invention a trait à un procédé pour déterminer les caractéristiques de la tension électrique d'une installation électrique alimentée par un générateur. L'invention concerne, encore, un dispositif pour la mise en oeuvre de ce procédé.

L'invention concerne le domaine de la conception et de la fabrication des dispositifs de détection de la tension électrique régnant au niveau d'une installation électrique.

L'on connaît, d'ores et déjà, des dispositifs de détection de la tension qui adoptent, par exemple, la forme d'un détecteur de type résistif qui nécessite, pour un fonctionnement approprié, d'être raccordé à la terre (ou à la masse de l'installation électrique) par le biais d'un câble. La présence d'un tel raccordement par câble présente un certain nombre d'inconvénients, plus particulièrement dans le cas d'une intervention sur une ligne à haute tension située à une hauteur importante.

En effet, un tel dispositif de détection est, usuellement, situé à l'extrémité d'une perche isolante manipulée par un opérateur de sorte que, pour raccorder ce dispositif à la terre, il est indispensable de disposer d'un câble de grande longueur et d'un poids conséquent qu'il convient d'amener sur site, notamment en le portant à la main.

Selon un autre inconvénient, ce câble de raccordement doit être solidement et sécuritairement fixé à la terre (ou à la masse de l'installation) par l'intermédiaire d'un organe de liaison adéquat. La connexion et la déconnexion doivent respecter une procédure stricte de sécurité. En effet, toute déconnexion intempestive de cet organe de liaison, alors que le dispositif de détection est au contact de l'installation sous tension, conduit celui-ci à être à un potentiel particulièrement élevé, voire maximal, ce qui représente un danger substantiel pour l'opérateur. Il en est de même dans le cas d'une rupture de ce câble dont l'extrémité restant connectée est à un potentiel particulièrement élevé, voire maximal.

Encore un autre inconvénient consiste en ce qu'un tel dispositif résistif présente une fragilité non négligeable de son élément résistif. La défaillance de celui-ci pouvant conduire à une mise en court-circuit de la totalité de l'installation que l'on cherchait à caractériser.

Il est, encore, connu des dispositifs de type capacitif qui ne nécessitent aucun raccordement filaire à la terre ou à la masse de l'installation. Cependant, de tels dispositifs unipolaires de cette conception peuvent uniquement détecter des tensions alternatives, à l'exclusion des tensions continues. Le Document -US 4 316 254 décrit un instrument de mesure portatif d'angle de phase

La présente invention se veut à même de remédier aux inconvénients des dispositifs de l'état de la technique par le biais, d'une part, d'un dispositif de type unipolaire conçu apte à mesurer des tensions continues ainsi qu'alternatives et, d'autre part, d'un procédé mis en oeuvre par un tel dispositif.

A cet effet, l'invention concerne un procédé pour déterminer les caractéristiques de la tension électrique d'une installation électrique alimentée par un générateur. Ce procédé est caractérisé en ce qu'il consiste :
- à générer au moins une perturbation électrique entre au moins deux points d'un circuit électrique séparés par une couche diélectrique, ceci par le biais d'un générateur de tension associé à ce circuit électrique ;
- à relever, aux bornes d'une première impédance que comporte ce circuit électrique, un premier courant électrique dont l'établissement est provoqué par la ou les perturbations électriques générées ;

- à mettre, ensuite, en contact une électrode associée à ce circuit électrique avec un point de l'installation électrique ;
- à relever, aux bornes d'une seconde impédance que comporte ce circuit électrique et qui est associée à cette électrode, un second courant électrique établi du fait de cette mise en contact ;
- à relever l'évolution du premier courant électrique aux bornes de la première impédance du fait de cette mise en contact;
- à déterminer les caractéristiques de la tension électrique de l'installation à partir, d'une part, de l'évolution du premier courant électrique relevé et, d'autre part, des caractéristiques du second courant électrique relevé.

L'invention concerne, encore, un dispositif pour déterminer les caractéristiques de la tension électrique d'une installation électrique. Ce dispositif est caractérisé par le fait qu'il comporte :
- des moyens pour générer au moins une perturbation électrique entre au moins deux points d'un circuit électrique que comporte ce dispositif et qui sont séparés par une couche diélectrique ;
- des moyens pour relever, aux bornes d'une première impédance que comporte ce circuit électrique, un premier courant électrique dont l'établissement est provoqué par la ou les perturbations électriques générées ainsi que l'évolution de ce premier courant électrique ;
- une électrode, associée à ce circuit électrique, destinée à être mise en contact avec un point de l'installation électrique ;
- des moyens pour relever, aux bornes d'une seconde impédance que comporte le circuit électrique et qui est associée à ladite électrode, un second courant électrique établi du fait de cette mise en contact ;
- des moyens pour déterminer les caractéristiques de la tension électrique de l'installation à partir, d'une part, de l'évolution du premier courant électrique relevé et, d'autre part, des caractéristiques du second courant électrique relevé.

Les avantages de la présente invention consistent en ce que le dispositif ne nécessite pas de raccordement filaire à la terre ou à un autre point de l'installation électrique contrôlée.

De plus, l'invention permet de déterminer, d'une part, l'état de tension (présence ou absence de tension), d'autre part, le type de tension (alternative ou continue) et, d'autre part encore, le niveau de tension de l'installation électrique.

D'autres buts et avantages de la présente invention apparaîtront au cours de la description qui va suivre se rapportant à des modes de réalisation qui ne sont donnés qu'à titre d'exemples indicatifs et non limitatifs.

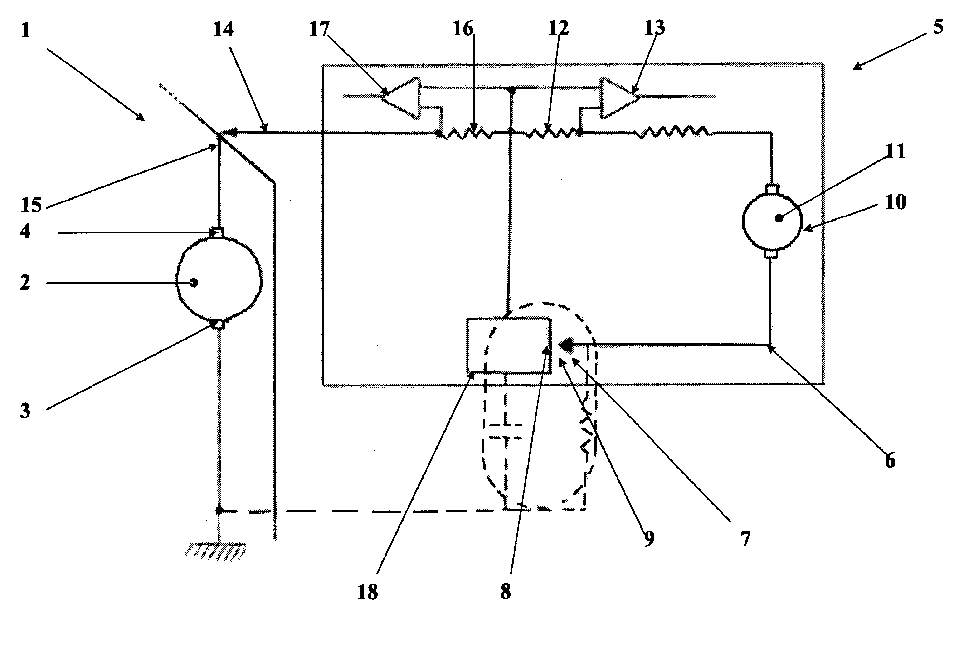

La compréhension de cette description sera facilitée en se référant au dessin joint en annexe et dans lequel la figure unique correspond à une vue schématisée du dispositif selon l'invention, raccordé à l'installation dont il convient de déterminer les caractéristiques de la tension électrique.

L'invention concerne le domaine de la détection, voire de la détermination des caractéristiques, d'une tension électrique régnant au niveau d'une installation électrique 1 alimentée par un générateur 2 comportant plusieurs bornes 3, 4, dont l'une 3 est, selon le cas, raccordée à la terre (figure en annexe) ou flottante.

La présente invention trouvera une application toute particulière dans le cadre d'installations électriques de type fixe, plus particulièrement des installations électriques de haute tension, voire de très haute tension, notamment des lignes électrifiées sans, toutefois, que la présente invention n'y soit, aucunement, limitée.

L'invention concerne, alors, d'une part, un procédé pour déterminer les caractéristiques de la tension électrique d'une telle installation électrique 1 et, d'autre part, un dispositif 5 pour déterminer les caractéristiques de la tension électrique d'une telle installation électrique 1, un tel dispositif 5 étant, plus particulièrement, conçu apte à mettre en oeuvre ledit procédé.

Tel que visible sur la figure en annexe, ce dispositif 5 comporte un circuit électrique 6 au niveau duquel sont définis au moins deux points 7, 8 séparés par une couche diélectrique 9 qui présente, d'une part, une capacité Ct et, d'autre part, une résistance Rt. A ce propos, il convient d'observer que cette couche diélectrique 9 peut, par exemple et de préférence, être constituée par une couche d'air.

Ce dispositif 5 comporte, également, des moyens 10 pour générer au moins une perturbation électrique entre au moins deux des points 7, 8 susmentionnés du circuit électrique 6 et séparés par une telle couche diélectrique 9. Pour ce faire, ces moyens 10 sont raccordés, selon le cas directement ou indirectement, à au moins ces deux points 7, 8.

A ce propos, on observera que les moyens 10 pour générer au moins une telle perturbation électrique sont constitués par des moyens aptes à générer un état particulier de la matière, notamment un plasma, entre au moins deux points 7, 8 du circuit électrique 6, donc au niveau de ladite couche diélectrique 9.

Selon un mode particulier de réalisation de l'invention, ces moyens 10 pour générer au moins une perturbation électrique sont constitués par des moyens aptes à générer au moins un arc électrique entre au moins deux points 7, 8 du circuit électrique 6.

Tel que visible sur la figure en annexe, les moyens 10 pour générer au moins une perturbation entre au moins deux points 7, 8 du circuit 6 sont, de préférence, raccordés, d'une part et directement, à l'un 7 de ces points 7, 8 et, d'autre part et indirectement, à un autre 8 de ces points 7, 8.

Une caractéristique additionnelle consiste en ce que les moyens 10 pour générer au moins une perturbation entre au moins deux de ces points 7, 8 sont raccordés, directement ou indirectement, à une ou plusieurs bornes définies au niveau d'un premier point 7 du circuit 6, notamment constitué par une première branche que comporte ce circuit 6, et/ou à une ou plusieurs bornes définies au niveau d'un second point 8 de ce circuit 6, notamment constitué par une seconde branche de ce circuit 6.

Un mode de réalisation particulier consiste à raccorder ces moyens 10, au niveau de ce premier point 7 et/ou au niveau de ce second point 8, à une pluralité de bornes.

La présence d'une pluralité de ces bornes permet de générer au moins une perturbation électrique entre, d'une part, une ou plusieurs bornes définies au niveau du premier point 7 du circuit 6 et, d'autre part, une ou plusieurs bornes définies au niveau du second point 8 de ce circuit 6.

A ce propos, on observera que la pluralité de bornes définies au niveau du premier point 7 et/ou du second point 8 permet de générer une pluralité de perturbations (notamment une perturbation par borne) qui se traduisent par l'établissement d'une pluralité de courants induits dans la première impédance 12.

Un mode particulier de réalisation de l'invention consiste, alors, à générer une perturbation positive et/ou une perturbation négative (plus particulièrement un arc électrique positif et/ou un arc électrique négatif), entre, d'une part, une ou plusieurs bornes (de préférence une pluralité de bornes) définies au niveau du premier point 7 et, d'autre part, un second point 8, notamment une ou plusieurs bornes de ce second point 8.

Un tel mode de réalisation trouvera un intérêt tout particulier dans le cas d'une installation à courant continu pour laquelle il est, alors, possible de déterminer la polarité du point contrôlé d'une telle installation.

Ce mode de réalisation trouvera, également, un intérêt dans le cas d'une installation à courant alternatif, plus particulièrement dans le cadre de très hautes tensions ou dans un environnement perturbé, conditions dans lesquelles il est particulièrement difficile de déterminer les caractéristiques d'une tension électrique par le biais des dispositifs de l'état de la technique.

Selon une caractéristique additionnelle, les moyens 10 pour générer au moins une perturbation électrique sont constitués par un générateur de tension 11 associé au circuit électrique 6 (ou que comporte ce dernier 6) et raccordé (plus particulièrement de manière directe) à l'un 7 des points 7, 8 entre lesquels au moins une telle perturbation électrique est générée.

Une autre caractéristique consiste en ce que le circuit électrique 6 comporte, encore, une première impédance 12 présentant, d'une part, une première borne raccordée aux moyens 10 pour générer au moins une perturbation électrique entre au moins deux points 7, 8 du circuit 6. Cette première impédance 12 présente, d'autre part, une seconde borne raccordée à l'un 8 des points 7, 8 du circuit 6, d'une part, entre lesquels 7, 8 est générée au moins une perturbation électrique et, d'autre part, autre que celui 7 raccordé aux moyens 10 pour générer au moins une telle perturbation. Ceci étant, lesdits moyens 10 sont, alors, raccordés à ce point 8 de manière indirecte et par l'intermédiaire de ladite impédance 12.

Le dispositif 5 comporte, alors, des moyens 13 pour relever, aux bornes de cette première impédance 12, d'une part, un premier courant électrique dont l'établissement est provoqué par la ou les perturbations électriques générées par les moyens 10 et, d'autre part, l'évolution de ce premier courant électrique. A ce propos, on observera que ce premier courant électrique établi est fonction des impédances (capacité Ct et résistance Rt de la couche diélectrique 9 susmentionnée).

Une autre caractéristique de l'invention consiste en ce que le dispositif 5 comporte une électrode 14, associée au circuit électrique 6, et destinée à être mise en contact avec un point 15 de l'installation électrique 1 au niveau de laquelle on détermine les caractéristiques de la tension électrique.

Tel que visible sur la figure en annexe, le circuit électrique 6 de ce dispositif 5 comporte, également, une seconde impédance 16 présentant, d'une part, une première borne raccordée à ladite électrode 14 et, d'autre part, une seconde borne raccordée à l'un 8 des points 7, 8 du circuit 6, d'une part, entre lesquels 7, 8 est générée au moins une perturbation électrique et, d'autre part, autre que celui 7 raccordé aux moyens 10 pour générer au moins une telle perturbation.

Le dispositif 5 selon l'invention comporte, alors, des moyens 17 pour relever, aux bornes de cette seconde impédance 16 (que comporte le circuit électrique 6 et qui est associée à ladite électrode 14), un second courant électrique établi dans le circuit électrique 6 du fait de la mise en contact de cette électrode 14 avec le point 15 de l'installation électrique 1.

Selon une autre caractéristique de l'invention, le dispositif 5 comporte des moyens (non représentés) pour déterminer les caractéristiques de la tension électrique de l'installation 1 à partir, d'une part, de l'évolution du premier courant électrique relevé par le biais des moyens 13 et, d'autre part, des caractéristiques du second courant électrique relevé par le biais des moyens 17.

Tel qu'évoqué ci-dessus, la première 12 et/ou la seconde 16 impédance sont raccordées à l'un 8 des points 7, 8 du circuit 6, d'une part, entre lesquels 7, 8 est générée au moins une perturbation électrique et, d'autre part, autre que celui 7 raccordé aux moyens 10 pour générer au moins une telle perturbation.

Un tel raccordement peut être assuré de manière directe ou, et de préférence, par le biais d'un boîtier électronique 18, d'une part, que comporte le dispositif 5, d'autre part, qui est associé au circuit électrique 6 ou que comporte ce dernier 6 et, d'autre part encore, raccordé à la première 12 et/ou à la seconde 16 impédance.

Tel qu'évoqué ci-dessus, la présente invention trouvera une application particulière dans le domaine des installations électriques constituées par des lignes électriques, notamment à haute tension. De telles lignes électriques sont, usuellement, de type aérien de sorte que pour mettre en contact l'électrode 14 avec un point 15 d'une telle installation 1, il convient d'approcher le dispositif 5 de ce point 15. Pour ce faire et selon une caractéristique additionnelle de l'invention, le dispositif 5 est implanté à l'extrémité d'une perche isolante destinée à être manipulée par un opérateur.

L'invention concerne, également, un procédé pour déterminer les caractéristiques de la tension électrique d'une installation électrique 1 alimentée par un générateur 2.

Ce procédé consiste :
- à générer au moins une perturbation électrique entre au moins deux points 7, 8 d'un circuit électrique 6 séparés par une couche diélectrique 9, ceci par le biais de moyens 10 pour générer au moins une perturbation entre au moins deux de ces points 7, 8 ;
- à relever, aux bornes d'une première impédance 12 que comporte ce circuit électrique 6, un premier courant électrique dont l'établissement est provoqué par la ou les perturbations électriques générées ;
- à mettre, ensuite, en contact une électrode 14 associée à ce circuit électrique 6 (ou que comporte ce dernier 6) avec un point 15 de l'installation électrique 1 ;
- à relever, aux bornes d'une seconde impédance 16 que comporte ce circuit électrique 6 et qui est associée à cette électrode 14, un second courant électrique établi du fait de cette mise en contact ;
- à relever l'évolution du premier courant électrique aux bornes de la première impédance 12 du fait de cette mise en contact;
- à déterminer les caractéristiques de la tension électrique de l'installation 1 à partir, d'une part, de l'évolution du premier courant électrique relevé et, d'autre part, des caractéristiques du second courant électrique relevé.

A ce propos, on observera que les moyens 10 pour générer au moins une perturbation entre au moins deux de ces points 7, 8 sont constitués par un générateur de tension 11 associé au circuit électrique 6 ou que comporte ce dernier 6.

Selon une autre caractéristique de ce procédé, lorsque l'on génère au moins une perturbation électrique par le générateur 11, l'on génère, par le biais de ce dernier 11, un état particulier de la matière, notamment un plasma, entre au moins deux points 7, 8 du circuit électrique 6, plus particulièrement au niveau de la couche diélectrique 9.

En fait, lorsque l'on génère au moins une perturbation électrique par ce générateur 11, l'on génère, par le biais de ce dernier 11, un ou plusieurs arcs électriques établis entre au moins deux points 7, 8 du circuit électrique 6.

A ce propos, on observera qu'une telle perturbation est générée entre, d'une part, un premier point 7 du circuit 6 raccordé au générateur 11 et, d'autre part, un second point 8 du circuit 6 raccordé au moins à la première impédance 12, voire encore à la seconde impédance 16.

Selon un mode particulier de réalisation et tel qu'évoqué ci-dessus, lorsqu'on génère au moins une perturbation électrique entre au moins deux points 7, 8 du circuit 6, l'on génère cette ou ces perturbations entre, d'une part, une ou plusieurs bornes (de préférence une pluralité de bornes) définies au niveau d'un premier point 7 du circuit 6 et, d'autre part, un second point 8, notamment une ou plusieurs bornes définies au niveau de ce second point 8.

Un mode préféré de réalisation consiste en ce qu'au moins une telle perturbation (plus particulièrement au moins un arc électrique) est générée entre, d'une part, une pluralité de bornes définies au niveau du premier point 7 du circuit 6 et, d'autre part, un second point 8 de ce circuit 6, notamment une ou plusieurs bornes définies au niveau de ce second point 8.

A ce propos, on observera que la pluralité de bornes définies au niveau du premier point 7 et/ou du second point 8 permet de générer une pluralité de perturbations (notamment une perturbation par borne) qui se traduisent par l'établissement d'une pluralité de courants induits dans la première impédance 12.

Tel qu'évoqué ci-dessus, un mode particulier de réalisation de l'invention consiste, alors, à générer une perturbation positive et/ou une perturbation négative (plus particulièrement un arc électrique positif et/ou un arc électrique négatif), entre, d'une part, une ou plusieurs bornes définies au niveau du premier point 7 et, d'autre part, une ou plusieurs bornes définies au niveau du second point 8.

Plus particulièrement, l'invention peut consister à générer, d'une part, une perturbation positive entre une première borne définie au niveau du premier point 7 et un second point 8 et, d'autre part, une perturbation négative entre une seconde borne définie au niveau du premier point 7 et le second point 8.

Un tel mode de réalisation permet, avantageusement, de déterminer la polarité de la tension électrique d'une installation 1 à courant continu, ceci à partir des courants électriques induits dans les première 12 et seconde 16 impédances.

Tel qu'évoqué ci-dessus, le dispositif 5 comporte, au niveau du second point 8 de ce circuit 6, un boîtier électronique 18, d'une part, associé à ce circuit 6 ou que comporte ce dernier et, d'autre part, raccordé au moins à la première impédance 12, voire encore à la seconde impédance 16 que comporte ce circuit 6.

Ceci étant, l'invention consiste, alors, en ce que, lorsqu'on génère au moins une perturbation électrique entre deux points 7, 8 du circuit 6, on génère une telle perturbation entre, d'une part, un premier point 7 de ce circuit 6 et, d'autre part, ledit boîtier électronique 18 susmentionné.

## Revendications

1. Procédé pour déterminer les caractéristiques de la tension électrique d'une installation électrique (1) alimentée par un générateur (2), le procédé consiste :
- à générer au moins une perturbation électrique entre au moins deux points (7, 8) d'un circuit électrique (6) séparés par une couche diélectrique (9), ceci par le biais d'un générateur de tension (11) associé à ce circuit électrique (6) ;
- à relever, aux bornes d'une première impédance (12) que comporte ce circuit électrique (6), un premier courant électrique dont l'établissement est provoqué par la ou les perturbations électriques générées ;
- à mettre, ensuite, en contact une électrode (14) associée à ce circuit électrique (6) avec un point (15) de l'installation électrique (1) ; **caractérisé par le fait que** le procédé consiste en plus
- à relever, aux bornes d'une seconde impédance (16) que comporte ce circuit électrique (6) et qui est associée à cette électrode (14), un second courant électrique établi du fait de cette mise en contact ;
- à relever l'évolution du premier courant électrique aux bornes de la première impédance (12) du fait de cette mise en contact;
- à déterminer les caractéristiques de la tension électrique de l'installation (1) à partir, d'une part, de l'évolution du premier courant électrique relevé et, d'autre part, des caractéristiques du second courant électrique relevé.

2. Procédé pour déterminer les caractéristiques de la tension électrique d'une installation électrique (1) selon la revendication 1, **caractérisé par le fait que**, lorsque l'on génère une perturbation électrique par le générateur (11), l'on génère, par le biais de ce dernier (11), un état particulier de la matière, notamment un plasma, entre au moins deux points (7, 8) du circuit électrique (6).

3. Procédé pour déterminer les caractéristiques de la tension électrique d'une installation électrique (1) selon l'une quelconque des revendications précédentes, **caractérisé par le fait que**, lorsque l'on génère une perturbation électrique par le générateur (11), l'on génère, par le biais de ce dernier (11), un ou plusieurs arcs électriques établis entre au moins deux points (7, 8) du circuit électrique (6).

4. Procédé pour déterminer les caractéristiques de la tension électrique d'une installation électrique (1) selon l'une quelconque des revendications précédentes, **caractérisé par le fait que**, lorsqu'on génère au moins une perturbation électrique entre deux points (7 ; 8) du circuit (6), l'on génère une telle perturbation entre, d'une part, un premier point (7) du circuit (6) raccordé au générateur (11) et, d'autre part, un second point (8) du circuit raccordé au moins à la première impédance (12), voire encore à la seconde impédance (16).

5. Procédé pour déterminer les caractéristiques de la tension électrique d'une installation électrique (1) selon l'une quelconque des revendications précédentes, **caractérisé par le fait que**, lorsqu'on génère au moins une perturbation électrique entre au moins deux points (7, 8) du circuit (6), l'on génère cette ou ces perturbations entre, d'une part, une ou plusieurs bornes définies au niveau d'un premier point (7) du circuit (6), notamment constitué par une première branche que comporte ce circuit (6) et, d'autre part, une ou plusieurs bornes définies au niveau d'un second point (8) de ce circuit (6), notamment constitué par une seconde branche que comporte ce circuit (6).

6. Procédé pour déterminer les caractéristiques de la tension électrique d'une installation électrique (1) selon l'une quelconque des revendications précédentes, **caractérisé par le fait que**, lorsqu'on génère au moins une perturbation électrique entre deux points (7, 8) du circuit (6), on génère une telle perturbation entre, d'une part, un premier point (7) de ce circuit (6) et, d'autre part, un boîtier électronique (18) associé à ce circuit (6) ou que comporte ce dernier (6), ceci au niveau d'un second point (8) de ce circuit (6).

7. Dispositif (5) pour déterminer les caractéristiques de la tension électrique d'une installation électrique (1),
il comporte:
- des moyens (10) pour générer au moins une perturbation électrique entre au moins deux points (7, 8) d'un circuit électrique (6) que comporte ce dispositif (5) et qui sont séparés par une couche diélectrique (9) ;
- des moyens (13) pour relever, aux bornes d'une première impédance (12) que comporte ce circuit électrique (6), un premier courant électrique dont l'établissement est provoqué par la ou les perturbations électriques générées ainsi que l'évolution de ce premier courant électrique ;
- une électrode (14), associée à ce circuit électrique (6), destinée à être mise en contact avec un point (15) de l'installation électrique (1) ; **caractérisé par le fait qu'**il comporte :
- des moyens (17) pour relever, aux bornes d'une seconde impédance (16) que comporte le circuit électrique (6) et qui est associée à ladite électrode (14), un second courant électrique établi du fait de cette mise en contact ;
- des moyens pour déterminer les caractéristiques de la tension électrique de l'installation (1) à partir, d'une part, de l'évolution du premier courant électrique relevé et, d'autre part, des caractéristiques du second courant électrique relevé.

8. Dispositif (5) pour déterminer les caractéristiques de la tension électrique d'une installation électrique (1) selon la revendication 7, **caractérisé par le fait que** les moyens (10) pour générer au moins une perturbation électrique sont constitués par des moyens aptes à générer un état particulier de la matière, notamment un plasma, entre au moins deux points (7, 8) du circuit électrique (6).

9. Dispositif (5) pour déterminer les caractéristiques de la tension électrique d'une installation électrique (1) selon l'une quelconque des revendications 7 ou 8, **caractérisé par le fait que** les moyens (10) pour générer au moins une perturbation électrique sont constitués par des moyens aptes à générer au moins un arc électrique entre au moins deux points (7, 8) du circuit électrique (6).

10. Dispositif (5) pour déterminer les caractéristiques de la tension électrique d'une installation électrique (1) selon l'une quelconque des revendications 7 à 9, **caractérisé par le fait que** les moyens (10) pour générer au moins une perturbation électrique entre au moins deux points (7, 8) du circuit (6) sont raccordés à une ou plusieurs bornes, en un premier (7) de ces points et/ou en un second (8) de ces points.

11. Dispositif (5) pour déterminer les caractéristiques de la tension électrique d'une installation électrique (1) selon l'une quelconque des revendications 7 à 10, **caractérisé par le fait que** les moyens (10) pour générer au moins une perturbation électrique sont constitués par un générateur de tension (11) associé au circuit électrique (6) et raccordé au moins à l'un (7) des points (7, 8) entre lesquels au moins une telle perturbation électrique est générée.

12. Dispositif (5) pour déterminer les caractéristiques de la tension électrique d'une installation électrique (1) selon l'une quelconque des revendications 7 à 11, **caractérisé par le fait que** la première impédance (12) comporte, d'une part, une première borne raccordée aux moyens (10) pour générer au moins une perturbation électrique entre au moins deux points (7, 8) du circuit (6) et, d'autre part, une seconde borne raccordée à l'un (8) des points (7, 8) du circuit (6), d'une part, entre lesquels est générée au moins une perturbation électrique et, d'autre part, autre que celui (7) raccordé aux moyens (10) pour générer au moins une telle perturbation.

13. Dispositif (5) pour déterminer les caractéristiques de la tension électrique d'une installation électrique (1) selon l'une quelconque des revendications 7 à 12, **caractérisé par le fait que** la seconde impédance (16) comporte, d'une part, une première borne raccordée à l'électrode (14) et, d'autre part, une seconde borne raccordée à l'un (8) des points (7, 8) du circuit (6), d'une part, entre lesquels est générée au moins une perturbation électrique et, d'autre part, autre que celui (7) raccordé aux moyens (10) pour générer au moins une telle perturbation.

14. Dispositif (5) pour déterminer les caractéristiques de la tension électrique d'une installation électrique (1) selon l'une quelconque des revendications 7 à 13, **caractérisé par le fait que** le dispositif (5) comporte un boîtier électronique (18), associé à ce circuit (6) ou que comporte ce dernier (6), et implanté au niveau de l'un (8) des points (7, 8) du circuit (6), d'une part, entre lesquels est générée au moins une perturbation et, d'autre part, autre que celui (7) raccordé aux moyens (10) pour générer au moins une telle perturbation électrique.

15. Dispositif (5) pour déterminer les caractéristiques de la tension électrique d'une installation électrique (1) selon l'une quelconque des revendications 7 à 14, **caractérisé par le fait que** le dispositif (5) est implanté à l'extrémité d'une perche isolante destinée à être manipulée par un opérateur.

## Claims

1. Method for determining the characteristics of the voltage of an electrical system (1) supplied by a generator (2), the method consisting in:
- generating at least one electric disturbance between at least two points (7, 8) of an electric circuit (6) separated by a dielectric layer (9), by means of a voltage generator (11) associated with this electric circuit (6);
- recording, at the terminals of a first impedance (12) this electric circuit includes (6), a first electric current the establishment of which is caused by the generated electric disturbances;
- then bringing into contact an electrode (14) associated with this electric circuit (6) with a point (15) of the electrical system (1);
wherein the method consists in addition in:
- recording, at the terminals of a second impedance (16) this electric circuit includes (6), and which is associated with this electrode (14), a second electric current established as a result of this bringing into contact;
- recording the evolution of the first electric current at the terminals of the first impedance (12) as a result of this bringing into contact;
- determining the characteristics of the voltage of the system (1) based on, on the one hand, the evolution of the first electric current recorded and, on the other hand, the characteristics of the second electric current recorded.

2. Method for determining the characteristics of the voltage of an electrical system (1) according to claim 1, wherein, when an electric disturbance is generated by the generator (11), a particular state of the matter, in particular a plasma, is generated by means of the latter (11) between at least two points (7, 8) of the electric circuit (6).

3. Method for determining the characteristics of the voltage of an electrical system (1) according to any of the preceding claims, wherein, when an electric disturbance is generated by the generator (11), one or more electric arcs established between at least two points (7, 8) of the electric circuit (6) are generated by means of the latter (11).

4. Method for determining the characteristics of the voltage of an electrical system (1) according to any of the preceding claims, wherein, when at least one electric disturbance is generated between two points (7; 8) of the circuit (6), such a disturbance is generated between, on the one hand, a first point (7) of the circuit (6) connected to the generator (11) and, on the other hand, a second point (8) of the circuit connected at least to the first impedance (12), and even also to the second impedance (16).

5. Method for determining the characteristics of the voltage of an electrical system (1) according to any of the preceding claims, wherein, when at least one electric disturbance is generated between at least two points (7, 8) of the circuit (6), this or these disturbances are generated between, on the one hand, one or more terminals defined at the level of a first point (7) of the circuit (6), in particular consisting of a first branch this circuit (6) includes and, on the other hand, one or more terminals defined at the level of a second point (8) of this circuit (6), in particular consisting of a second branch this circuit (6) includes.

6. Method for determining the characteristics of the voltage of an electrical system (1) according to any of the preceding claims, wherein, when at least one electric disturbance is generated between two points (7, 8) of the circuit (6), such a disturbance is generated between, on the one hand, a first point (7) of this circuit (6) and, on the other hand, an electronic box (18) connected to this circuit (6) or included in the latter (6), at the level of a second point (8) of this circuit (6).

7. Device (5) for determining the characteristics of the voltage of an electrical system (1), which includes:
- means (10) for generating at least one electric disturbance between at least two points (7, 8) of an electric circuit (6) this device (5) includes, and which are separated by a dielectric layer (9);
- means (13) for recording, at the terminals of a first impedance (12) this electric circuit includes (6), a first electric current the establishment of which is caused by the electric disturbances generated, as well as the evolution of this first electric current;
- an electrode (14), associated with this electric circuit (6), designed to be brought into contact with a point (15) of the electrical system (1);
wherein it includes:
- means (17) for recording, at the terminals of a second impedance (16) the electric circuit (6) includes, and which is associated with said electrode (14), a second electric current established as a result of this bringing into contact;
- means for determining the characteristics of the voltage of the system (1) based on, on the one hand, the evolution of the first electric current recorded and, on the other hand, the characteristics of the second electric current recorded.

8. Device (5) for determining the characteristics of the voltage of an electrical system (1) according to claim 7, wherein the means (10) for generating at least one electric disturbance consist of means capable of generating a particular state of the matter, in particular a plasma, between at least two points (7, 8) of the electric circuit (6).

9. Device (5) for determining the characteristics of the voltage of an electrical system (1) according to any of the claims 7 or 8, wherein the means (10) for generating at least one electric disturbance consist of means capable of generating at least one electric arc between at least two points (7, 8) of the electric circuit (6).

10. Device (5) for determining the characteristics of the voltage of an electrical system (1) according to any of the claims 7 through 9, wherein the means (10) for generating at least one electric disturbance between at least two points (7, 8) of the circuit (6) are connected to one or more terminals, at a first one (7) of these points and/or at a second one (8) of these points.

11. Device (5) for determining the characteristics of the voltage of an electrical system (1) according to any of the claims 7 through 10, wherein the means (10) for generating at least one electric disturbance consist of a voltage generator (11) associated with the electric circuit (6) and connected to at least one (7) of the points (7, 8) between which at least one such electric disturbance is generated.

12. Device (5) for determining the characteristics of the voltage of an electrical system (1) according to any of the claims 7 through 11, wherein the first impedance (12) includes, on the one hand, a first terminal connected to the means (10) for generating at least one electric disturbance between at least two points (7, 8) of the circuit (6) and, on the other hand, a second terminal connected to one (8) of the points (7, 8) of the circuit (6), on the one hand, between which is generated at least one electric disturbance and, on the other hand, different from the one (7) connected to the means (10) for generating at least one such disturbance.

13. Device (5) for determining the characteristics of the voltage of an electrical system (1) according to any of the claims 7 through 12, wherein the second impedance (16) includes, on the one hand, a first terminal connected to the electrode (14) and, on the other hand, a second terminal connected to one (8) of the points (7, 8) of the circuit (6), on the one hand, between which is generated at least one electric disturbance and, on the other hand, different from the one (7) connected to the means (10) for generating at least one such disturbance.

14. Device (5) for determining the characteristics of the voltage of an electrical system (1) according to any of the claims 7 through 13, wherein the device (5) includes an electronic box (18), associated with this circuit (6) or included in the latter (6), and installed at the level of one (8) of the points (7, 8) of the circuit (6), on the one hand, between which is generated at least one disturbance and, on the other hand, different from the one (7) connected to the means (10) for generating at least one such electric disturbance.

15. Device (5) for determining the characteristics of the voltage of an electrical system (1) according to any of the claims 7 through 14, wherein the device (5) is installed at the end of an insulating pole designed to be handled by an operator.

## Patentansprüche

1. Verfahren zur Bestirnmung der Eigenschaften der elektrischen Spannung einer elektrischen Anlage (1), die durch einen Generator (2) versorgt wird, wobei das Verfahren darin besteht:
- zumindest eine elektrische Störung zwischen wenigstens zwei Punkten (7, 8) eines Stromkreises (6), die durch eine nicht leitende Schicht (9) getrennt sind, und zwar vermittels eines Spannungsgenerators (11). der diesem Stromkreis (6) zugeordnet ist, zu erzeugen;
- an den Anschlussklemmen eines ersten Widerstandes (12), den dieser Stromkreis (6) umfasst, einen ersten elektrischen Strom abzulesen, dessen Entstehung durch die erzeugte elektrische Störung oder durch die erzeugten elektrischen Störungen verursacht ist;
- anschliessend eine Elektrode (14), die diesem Stromkreis (6) zugeordnet ist, mit einem Punkt (15) der elektrischen Anlage (1) in Kontakt zu setzen;
**dadurch gekennzeichnet, dass** das Verfahren außerdem darin besteht,
- an den Anschlussklemmen eines zweiten Widerstandes (16), den dieser Stromkreis (6) umfasst, und der dieser Elektrode (14) zugeordnet ist, einen zweiten elektrischen Strom abzulesen, der infolge dieser Kontaktherstellung entstanden ist;
- die Entstehung des ersten elektrischen Stromes an den Anschlussklemmen des ersten Widerstandes (12) infolge dieser Kontaktherstellung abzulesen;
- die Eigenschaften der elektrischen Spannung der Anlage (1), ausgehend, einerseits, von der Entstehung des ersten abgelesenen elektrischen Stromes, und, andererseits, von den Eigenschaften des zweiten abgelesenen elektrischen Stromes, zu bestimmen.

2. Verfahren zur Bestimmung der Eigenschaften der elektrischen Spannung einer elektrischen Anlage (1) nach Anspruch 1, **dadurch gekennzeichnet, dass**, wenn durch den Generator (11) eine elektrische Störung erzeugt wird, mit Hilfe dieses letzteren (11) zwischen wenigstens zwei Punkten (7, 8) des Stromkreises (6) ein besonderer Zustand des Materials, insbesondere ein Plasma, erzeugt wird.

3. Verfahren zur Bestimmung der Eigenschaften der elektrische Spannung einer elektrischen Anlage (1) nach irgendeinem der vorgehenden Ansprüche, **dadurch gekennzeichnet, dass**, wenn durch den Generator (11) eine elektrische Störung erzeugt wird, mit Hilfe dieses letzteren (11) ein oder mehrere elektrische Lichtbögen erzeugt werden, die sich zwischen wenigstens zwei Punkten (7, 8) des Stromkreises (6) bilden.

4. Verfahren zur Bestimmung der Eigenschaften der elektrischen Spannung einer elektrischen Anlage (1) nach irgendeinem der vorgehenden Ansprüche, **dadurch gekennzeichnet, dass**, wenn zumindest eine elektrische Störung zwischen zwei Punkten (7; 8) des Stromkreises (6) erzeugt wird, eine solche Störung zwischen, einerseits, einem ersten Punkt (7) des Stromkreises (6), der an dem Generator (11) angeschlossen ist, und, andererseits, einem zweiten Punkt (8) des Stromkreises, der zumindest an dem ersten Widerstand (12), ja sogar noch mit dem zweiten Widerstand (16) angeschlossen ist, erzeugt wird.

5. Verfahren zur Bestimmung der Eigenschaften der elektrischen Spannung einer elektrischen Anlage (1) nach irgendeinem der vorgehenden Ansprüche, **dadurch gekennzeichnet, dass**, wenn zumindest eine elektrische Störung zwischen wenigstens zwei Punkten (7, 8) des Stromkreises (6) erzeugt wird, diese Störung oder diese Störungen, einerseits, zwischen einer oder mehreren Anschlussklemmen, die im Bereich eines ersten Punktes (7) des Stromkreises (6) gebildet sind, der insbesondere durch eine erste Schaltungsverzweigung, die dieser Stromkreis (6) umfasst, gebildet ist, und, andererseits, zwischen einer oder mehreren Anschlussklemmen, die im Bereich eines zweiten Punktes (8) dieses Stromkreises (6) gebildet sind, der insbesondere durch eine zweite Schaltungsverzweigung, die dieser Stromkreis (6) umfasst, gebildet ist, erzeugt wird bzw. werden.

6. Verfahren zur Bestimmung der Eigenschaften der elektrischen Spannung einer elektrischen Anlage (1) nach irgendeinem der vorgehenden Ansprüche, **dadurch gekennzeichnet, dass**, wenn zumindest eine elektrische Störung zwischen zwei Punkten (7, 8) des Stromkreises (6) erzeugt wird, eine solche Störung zwischen, einerseits, einem ersten Punkt (7) dieses Stromkreises (6), und, andererseits, einem elektronischen Kasten (18), das diesem Stromkreis (6) zugeordnet ist, oder das dieser letztere (6), und zwar im Bereich eines zweiten Punktes (8) dieses Stromkreises (6), umfasst, erzeugt wird.

7. Vorrichtung (5) zur Bestimmung der Eigenschaften der elektrischen Spannung einer elektrischen Anlage (1), welche Folgendes umfasst:
- Mittel (10), um zumindest eine elektrische Störung zwischen wenigstens zwei Punkten (7, 8) eines Stromkreises (6), den diese Vorrichtung (5) umfasst, und die durch eine nicht leitende Schicht (9) getrennt sind, zu erzeugen;
- Mittel (13), um an den Anschlussklemmen eines ersten Widerstandes (12), den dieser Stromkreis (6) umfasst, einen ersten elektrischen Strom, dessen Entstehung durch die erzeugte elektrische Störung oder durch die erzeugten elektrischen Störungen verursacht ist, sowie den Verlauf dieses ersten elektrischen Stromes abzulesen;
- eine Elektrode (14), die diesem Stromkreis (6) zugeordnet ist, vorgesehen, um mit einem Punkt (15) der elektrischen Anlage (1) in Kontakt gesetzt zu werden;
**dadurch gekennzeichnet, dass** sie Folgendes umfasst:
- Mittel (17), um an den Anschlussklemmen eines zweiten Widerstandes (16), den der Stromkreis (6) umfasst, und der der besagten Elektrode (14) zugeordnet ist, einen zweiten elektrischen Strom abzulesen, der infolge dieser Kontaktherstellung entstanden ist;
- Mittel, um die Eigenschaften der elektrischen Spannung der Anlage (1) zu bestimmen, ausgehend, einerseits, von dem Verlauf des ersten abgelesenen elektrischen Stromes, und, andererseits, von den Eigenschaften des zweiten abgelesenen elektrischen Stromes.

8. Vorrichtung (5) zur Bestimmung der Eigenschaften der elektrischen Spannung einer elektrischen Anlage (1) nach Anspruch 7, **dadurch gekennzeichnet, dass** die Mittel (10), um zumindest eine elektrische Störung zu erzeugen, durch Mittel gebildet sind, die geeignet sind, um einen besonderen Zustand des Materials, insbesondere ein Plasma, zwischen wenigstens zwei Punkten (7, 8) des Stromkreises (6) zu schaffen.

9. Vorrichtung (5) zur Bestimmung der Eigenschaften der elektrischen Spannung einer elektrischen Anlage (1) nach irgendeinem der Ansprüche 7 oder 8, **dadurch gekennzeichnet, dass** die Mittel (10), um zumindest eine elektrische Störung zu erzeugen, durch Mittel gebildet sind, die geeignet sind, um zumindest einen elektrischen Lichtbogen zwischen wenigstens zwei Punkten (7, 8) des Stromkreises (6) zu erzeugen.

10. Vorrichtung (5) zur Bestimmung der Eigenschaften der elektrischen Spannung einer elektrischen Anlage (1) nach irgendeinem der Ansprüche 7 bis 9, **dadurch gekennzeichnet, dass** die Mittel (10), um zumindest eine elektrische Störung zwischen wenigstens zwei Punkten (7, 8) des Stromkreises (6) zu erzeugen, an einer oder an mehreren Anschlussklemmen in einem ersten (7) von diesen Punkten und/oder an einem zweiten (8) von diesen Punkten angeschlossen sind.

11. Vorrichtung (5) zur Bestimmung der Eigenschaften der elektrischen Spannung einer elektrischen Anlage (1) nach irgendeinem der Ansprüche 7 bis 10, **dadurch gekennzeichnet, dass** die Mittel (10), um zumindest eine elektrische Störung zu erzeugen, durch einen Spannungsgenerator (11) gebildet sind, der dem Stromkreis (6) zugeordnet ist und der zumindest an dem einen (7) von den Punkten (7, 8) angeschlossen ist, zwischen welchen zumindest eine solche elektrische Störung erzeugt ist.

12. Vorrichtung (5) zur Bestimmung der Eigenschaften der elektrischen Spannung einer elektrischen Anlage (I) nach irgendeinem der Ansprüche 7 bis 11, **dadurch gekennzeichnet, dass** der erste Widerstand (12), einerseits, eine erste Anschlussklemme, die an den Mitteln (10) angeschlossen ist, um zumindest eine elektrische Störung zwischen wenigstens zwei Punkten (7, 8) des Stromkreises (6) zu erzeugen, und, andererseits, eine zweite Anschlussklemme umfasst, die an dem einen (8) von den Punkten (7, 8) des Stromkreises (6) angeschlossen ist, zwischen welchen, einerseits, zumindest eine elektrische Störung erzeugt wird, und, andererseits, der von demjenigen (7), der an den Mitteln (10) angeschlossen ist, unterschiedlich ist, um zumindest eine solche Störung zu erzeugen.

13. Vorrichtung (5) zur Bestimmung der Eigenschaften der elektrischen Spannung einer elektrischen Anlage (1) nach irgendeinem der Ansprüche 7 bis 12, **dadurch gekennzeichnet, dass** der zweite Widerstand (16), einerseits, eine erste Anschlussklemme (14), die an der Elektrode angeschlossen ist, und, andererseits, eine zweite Anschlussklemme umfasst, die an dem einen (8) von den Punkten (7, 8) des Stromkreises (6) angeschlossen ist, zwischen welchen, einerseits, zumindest eine elektrische Störung erzeugt wird, und, andererseits, der von demjenigen (7), der an den Mitteln (10) angeschlossen ist, unterschiedlich ist, um zumindest eine solche Störung zu erzeugen.

14. Vorrichtung (5) zur Bestimmung der Eigenschaften der elektrischen Spannung einer elektrischen Anlage (1) nach irgendeinem der Ansprüche 7 bis 13, **dadurch gekennzeichnet, dass** die Vorrichtung (5) ein elektronisches Steuergerät (18) umfasst, das diesem Stromkreis (6) zugeordnet ist, oder das dieser letztere (6) umfasst, und welches im Bereich des einen (8) von den Punkten (7, 8) des Stromkreises (6) eingesetzt ist, zwischen welchen, einerseits, zumindest eine Störung erzeugt wird, und der, andererseits, der von demjenigen (7), der an den Mitteln (10) angeschlossen ist, unterschiedlich ist, um zumindest eine solche elektrische Störung zu erzeugen.

15. Vorrichtung (5) zur Bestimmung der Eigenschaften der elektrischen Spannung einer elektrischen Anlage (1) nach irgendeinem der Ansprüche 7 bis 14, **dadurch** Schaltstange bzw. Isolierstange eingesetzt ist, die vorgesehen sind, um von einem Bediener gehandhabt zu werden.
